# EUROPEAN PATENT SPECIFICATION

(11) **EP 1 750 490 B1**
(45) Date of publication and mention of the grant of the patent: **11.05.2011**
(21) Application number: 05291651.7
(22) Date of filing: 02.08.2005
(51) Int. Cl.: H05K 1/02, H01L 23/36, H01L 23/373

(54) **Cooling of an electronic power device**
Kühlung eines elektronischen Leistungsbauelementes
Refroidissement d'un dispositif électronique de puissance

(43) Date of publication of application: 07.02.2007
(73) Proprietor: Dunkermotoren GmbH, 79848 Bonndorf (DE)
(72) Inventor: Kramer, Oliver, 79848 Bonndorf (DE)
(74) Representative: Dreiss

(56) References cited:
- EP-A- 1 100 294
- EP-A- 1 253 636
- US-A- 4 755 249
- US-A- 4 858 073
- US-A- 5 168 348
- US-B1- 6 200 407

## Description

### Background of the invention

The invention relates to an arrangement comprising a multitude of power devices, in particular comprising a power transistor, and means for cooling the power devices, wherein the means comprise a separate metal face for each power device, and a method for producing this arrangement.

Such an arrangement is disclosed in EP 1 253 636 A1. A similar arrangement is disclosed in the commercial publication "Thermal Management Products" of Chomerics, Woburn, MA, USA, October 1999.

EP 1 253 636 A1 discloses an electronic equipment comprising a wiring board, electronic components mounted on said wiring board, and an insulating heat dissipation plate, wherein heat dissipation portions of the electronic components are directly connected to the heat dissipation plate with a heat conducting bonding material.

US 4,858,073 discloses a metal substrated printed circuit. On a metal substrate, a plastic coating is arranged, with a polyimide film on top of it for carrying copper foil structures. On top of the copper structures, a metal heat spreader is soldered. Further, on top of the metal heat spreader, a silicon die is soldered.

In electronic power devices, such as power transistors, heat is produced. Uncooled power devices require a sharp current limitation in order to work properly. When the power devices are used in an electric motor, for example, the current limitation also deteriorates the dynamics and the capacity of the electric motor.

In order to avoid such limitations, it is known to install a cooling onto the power devices. A typical cooling comprises a massive aluminium metal cooler glued or clamped onto the device to be cooled. For electrical isolation, a thin electrically isolating heat conductor foil is arranged between the power device and the metal cooler.

In the commercial publication of Chomerics, heat spreaders are described. A heat spreader comprises a copper foil sandwiched between electrically insulating films. The heat spreader is glued onto the device to be cooled, such as a chip or an IC (integrated circuit) device, with a pressure sensitive adhesive.

The coolings of the state of the art are laborious and expensive to install, since the installation requires manual work. Often the adhesion is inadequate, e.g. due to installation errors, or the adhesion deteriorates over time, leading to a poor cooling effect only.

### Object of the invention

It is therefore the object of the invention to provide a cooling for an electronic power device that is simple and inexpensive to install, and which offers a sufficient and reliable cooling capacity.

### Short description of the invention

This object is achieved, in accordance with the invention, by an arrangement as defined in claim 1. The installation by soldering offers a strong, durable and highly reliable kind of fixing of the metal face. The metal face is linked to the power device to be cooled with a low thermal resistance. The metal face is preferably a laminar piece of metal, but may also be comprised in a more complex or even massive metal component. The metal face distributes the heat over a large surface area, and the heat may be taken away by air convection and, at higher temperatures, by heat radiation. If desired, the metal face may be linked to further cooling components in order to increase the cooling effect within the total arrangement. The metal of the metal face must be solderable, such as copper or brass. The soldering can be automated easily, similar to mounting of a PCB, so that the installation costs can be reduced in series production. Typical electronic power devices to be cooled in accordance with the invention are devices that can be mounted on a PCB and include in particular MOSFETs, high power bipolar transistors and voltage regulators.

In accordance with the invention, the arrangement comprises a multitude of power devices. The more power devices to be cooled, the more costs can be saved with the invention. Since the metal faces of each power device are separate, they can be kept electrically isolated from each other.

Further in accordance with the invention, it is provided that the means comprise a printed circuit board (PCB), and that the PCB comprises a first side with the metal faces, with each power device soldered to one separate metal face. The use of a PCB allows to standardize and automate the installation of cooling means in accordance with the invention, i.e. the production of arrangements in accordance with the invention. Preferably, the PCB comprises a second side with a continuous metal surface area.

The PCB is flexible. By this means, non-linearly arranged power devices can be provided with a common PCB for cooling purposes. During production of the arrangement, the PCB can be held flat, but in use, the PCB can be bent corresponding to the desired power device positions.

The separate metal faces are arranged in series, and neighbouring metal faces interdigitate, in particular with interdigitating meanders. In other words, the edges of the metal faces are not straight, but are contorted, with the neighbouring edges separated a little but corresponding to each other. The metal of the metal faces strengthens the PCB material, so a straight bend along the edges (which probably would cause the PCB to break) in the PCB will not occur. Instead, the bend will follow the gap between the interdigitating edge lines, what is less straining for the PCB material. By this means, even inexpensive standard FR4 material can be used for the PCB at sufficient flexibility. Particularly preferred are wavelike edge contours.

In a preferred embodiment of the inventive arrangement, the metal face comprises a piece of sheet metal, in particular a piece of copper sheet metal. A piece of sheet metal is easy to handle and in particular suited for a separate cooling of a single electronic power device.

In a preferred embodiment of the inventive arrangement, the PCB comprises a thin electrically isolating foil. On the sides of this foil, the metal faces and the continuous metal surface area may be arranged. The foil prevents electrical short circuits, but only has minimal thermal resistance, so heat may be spread all over the metal surface area efficiently.

Also as a further embodiment, the PCB comprises a thin, non-metallic lacquering, in particular a solder-stopping lacquering, on at least part of the first and/or second side. The lacquering improves the heat radiation of metal surfaces, in particular at higher temperatures. The lacquering is not applied at surfaces intended for soldering.

An advantageous further embodiment is characterized in that the power devices are arranged arcuated. This arrangement is particularly useful in direct current electric motors.

Also within the scope of the present invention is a method for producing an inventive arrangement as defined in claim 10. So the SMD surface reflow procedure in accordance with the invention does not solder the electric contacts of the at least one power device, but the cooling tab. During this, the power devices lay on side, namely the side of the cooling tab. The inventive method is an inexpensive and easy to automate way to produce inventive arrangements. Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.
- Fig. 1: shows a schematic slant view of an embodiment of the inventive arrangement with seven MOSFETs installed on a circular electronic;
- Fig. 2a: shows the embodiment of Fig. 1 arranged flatly before installation in plan view;
- Fig. 2b: shows the embodiment of Fig. 2a in top view;
- Fig. 2c: shows the embodiment of Fig. 2a in side view;
- Fig. 3a: shows an embodiment of an inventive arrangement with a single power device and a copper sheet metal;
- Fig. 3b: shows the embodiment of Fig. 3a in top view;
- Fig. 3c: shows the embodiment of Fig. 3a in side view;
- Fig. 4: shows an embodiment of an inventive arrangement with eight power devices on a PCB with interdigitating metal faces;
- Fig. 5a: shows the distribution of copper metal faces on the first, top side of the PCB of Fig. 4;
- Fig. 5b: shows the distribution of solder stopping lacquering on the first, top side of the PCB of Fig. 4;
- Fig. 5c: shows the distribution of solder paste on the first, top side of the PCB of Fig. 4;
- Fig. 5d: shows the distribution of copper surface area on the second, bottom side of the PCB of Fig. 4;
- Fig. 5e: shows the distribution of solder stopping lacquering on the second, bottom side of the PCB of Fig. 4.

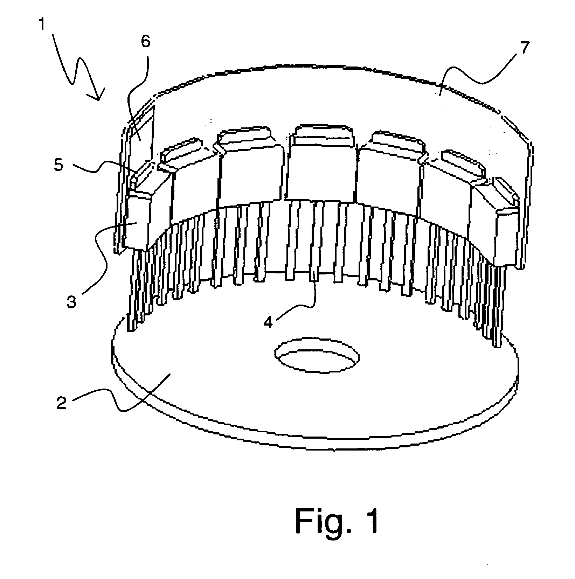

**Fig. 1** shows an inventive arrangement 1 installed on a circular electronic 2, which is, for example, part of an electric motor. The arrangement 1 comprises seven power devices 3, which are here MOSFETs. Their electric contacts 4 are soldered into the circular electronic 2. The power devices 3 have cooling tabs 5, which are soldered to metal faces 6 of a printed circuit board (=PCB) 7 of the arrangement 1. On the inner, first side of the PCB 7, there are seven separate metal faces 6 provided, each of which is soldered to a separate power device 3. The metal faces 6 are attached to an electrically isolating layer of the PCB 7. Only one metal face 6 is shown in detail in Fig. 1 for simplification. The outer, second side of the PCB 7, is almost completely covered with a continuous metal surface area (not shown in Fig. 1) which improves the cooling effect of the PCB 7.

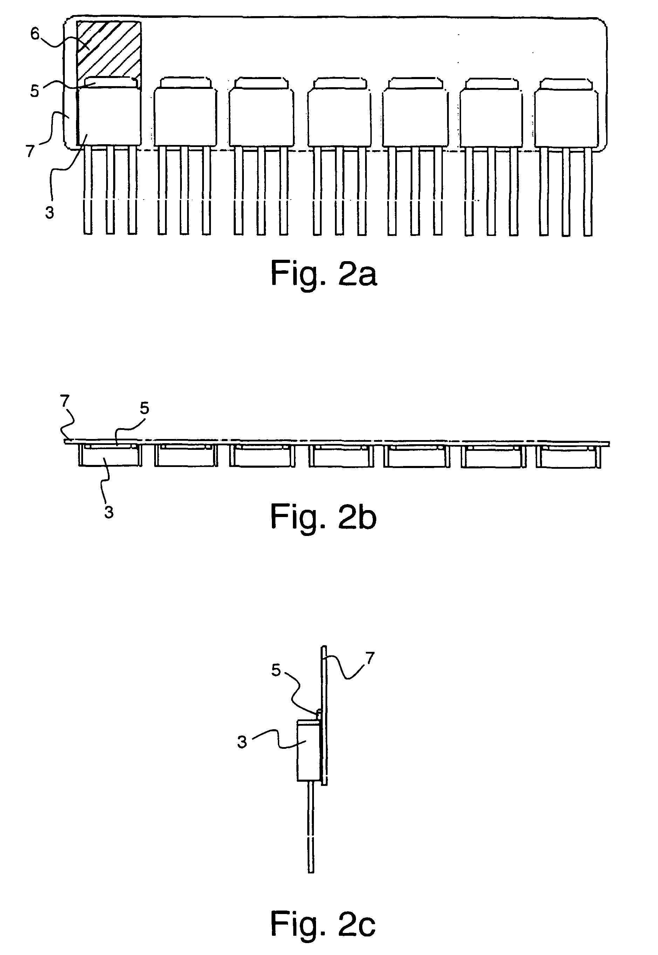

**Fig. 2a** shows the arrangement 1 before installation, i.e. in a flat arrangement of the power devices 3 one after another. At the rearward side face of each power device 3, there is the cooling tab 5 which is basically a piece of copper thermally linking the interior of the power device 3 with the surrounding for cooling purposes. Each cooling tab 5 typically is, in use, subject to a different voltage, so the cooling tabs 5 need to be electrically isolated. Therefore, the metal faces 6, to which the cooling tabs 5 are soldered to, are separated from neighboring metal faces 6 by a small gap. Only one metal face 6 is shown for simplification again. **Figs. 2b, 2c** show the arrangement of Fig. 2a in top view and in side view.

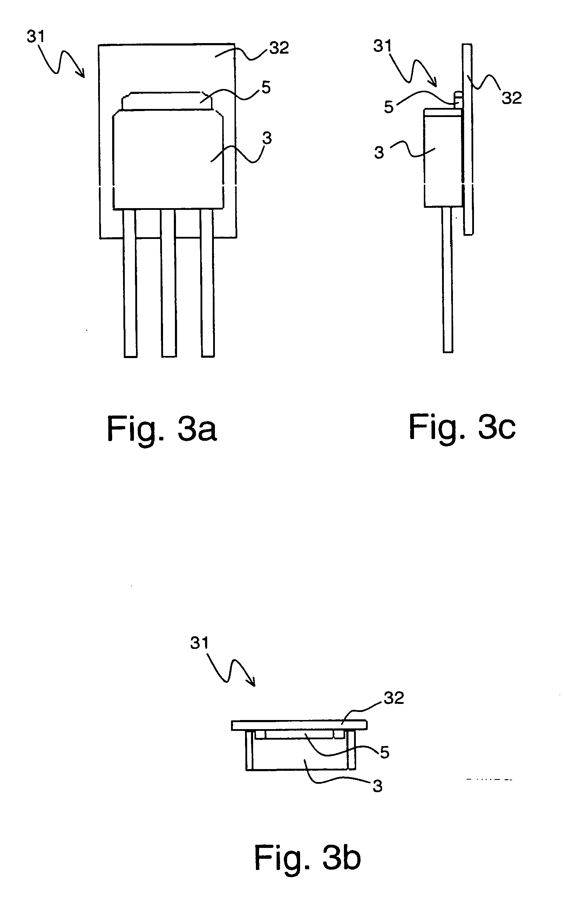

**Fig. 3a** shows another inventive arrangement 31, comprising a single power device 3 with a cooling tab 5. The cooling tab 5 of the power device 3 is directly soldered onto a piece of sheet metal 32 made of copper. The arrangement 31 may be mounted on a piece of electronic. **Figs. 3b, 3c** show the arrangement of Fig. 3a in top view and side view, respectively.

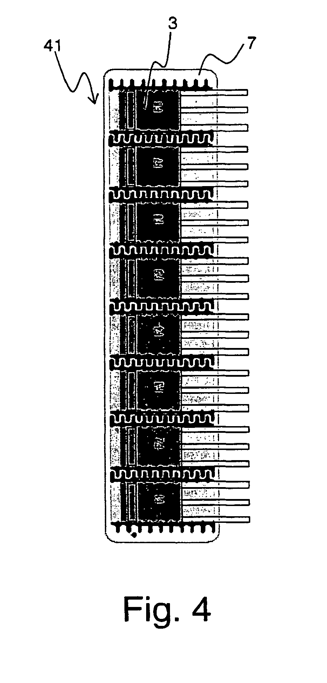

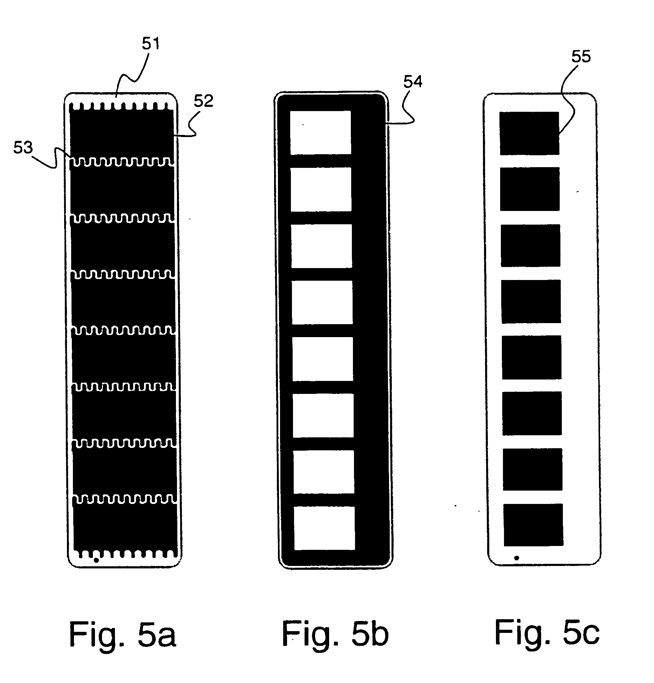

Figs. 4 and 5a through 5e detail the design of an inventive arrangement 41 which comprises eight power devices 3 (numbered F1 through F8) and a PCB 7, what is shown in **Fig. 4****.** The PCB 7 comprises several layers of different materials, which are detailed in Figs. 5a through 5e.

The basic component of the PCB 7 is a layer of electrically isolating material 51, whose edge is shown as the outer edge of the PCB in **Fig. 5a****.** In the embodiment of Fig. 4 and Figs. 5a-5e, this electrically isolating layer 51 is made of standard FR4 PCB material. Its thickness is about 0.2 mm. Such layers are typically used for multiplayer PCBs, but may be applied here directly, wherein its thin thickness grants flexibility.

On top of this electrically isolating layer 51, there is a copper layer provided, what is shown as black areas in Fig. 5a. The thickness of the copper layer is about 70 µm. The copper layer comprises eight metal faces 52, which are arranged in series. The edges 53 of neighboring metal faces 52 interdigitate with fingers in the shape of meanders. In Fig. 5a, the gap between neighboring metal faces 52 is curved s-shaped, so a sharp, straight bend of the PCB may not occur. This lessens the probability of a break in such an area. An evenly round curvature of the gap is preferred in this context. The gaps provide electrical isolation of the metal faces 52.

On top of the copper layer of Fig. 5a, there is a layer of solder-stopping lacquering 54, as shown in black in **Fig. 5b****.** The areas free of solder stopping lacquering are intended for soldering the cooling tabs of the power devices (see Fig. 4). The solder-stopping lacquering improves the heat radiation of the underlying copper layer (see Fig. 5a). The solder-stopping lacquering has a thickness of about 20 µm.

Also on top of the copper layer of Fig. 5a is a layer of soldering paste 55, as shown in black in **Fig. 5c****.** The areas of soldering paste 55 correspond to the areas where no solder-stopping lacquering has been applied (see Fig. 5b).

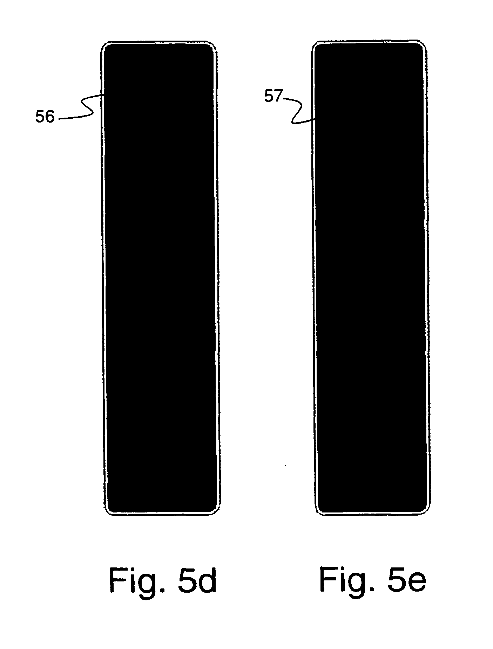

On the bottom side of the electrically isolating layer (compare Fig. 5a), there is a continuous metal surface area 56, as shown in black in **Fig. 5d****.** The continuous metal surface area here is a thin copper layer of about 70 µm thickness, which thermally short-circuits the separate metal faces of the top copper layer. It also improves the cooling effect of the total arrangement enormously.

The continuous metal surface area (compare Fig. 5d) is sealed with a thin layer of solder-stopping lacquering 57, which is shown in black in **Fig. 5e****.** The solder-stopping lacquering, which has a thickness of typically 20 µm, improves the heat radiation of the covered copper material of the continuous metal surface area.

In accordance with the invention, several arrangements of Figs. 4, 5a-5e may be produced on one large PCB sheet in parallel, wherein the separate arrangements are detached after completing the production of the PCB sheet. Typical PCB sheets comprise sixteen inventive arrangements, each of which comprises for example eight power devices. When producing the PCB sheet, an SMD reflow procedure may be applied in accordance with the invention. The power devices orient automatically with the aid of capillary forces and interfacial energies, what simplifies the production compared to conventional techniques using masks for component orientation. Note that different from the state of the art, the power devices are not oriented with the aid of the metal surfaces of their electric contacts ("legs"), but with the metal surfaces of their cooling tabs, which are located at a side face of the power devices.
Ssimilar production techniques may be applied with a single pieces of sheet metal soldered to one power device each, as described in Figs. 3a-3c, wherein a sheet of sheet metal replaces the PCB sheet, and the inventive arrangements are punched out of the sheet of sheet metal.

With the inventive arrangement, the electronic power devices are cooled sufficiently to overcome limitations of not cooled power devices. The additional costs are low, in particular compared with known cooling techniques.

## Claims

1. Arrangement (1, 31; 41) comprising a multitude of power devices (3), in particular comprising a power transistor, and means for cooling the power devices (3),
wherein the means comprise a separate metal face (6; 52) for each power device (3) and
a printed circuit board (=PCB) (7), the PCB (7) comprising a first side with the metal faces (6; 52), with
each power device (3) soldered to one separate metal face (6; 52), the separate metal faces (6; 52) being arranged in series, **characterized in that** the PCB (7) is flexible, and **in that** neighbouring metal faces (6; 52) interdigitate.

2. Arrangement according to claim 1, **characterized in that** the interdigitating neighboring metal faces (6; 52) have wavelike edge contours.

3. Arrangement (1, 31; 41) according to claim 1, **characterized in that** the metal face (6; 32) comprises a piece of sheet metal (32), in particular a piece of copper sheet metal.

4. Arrangement (1, 31; 41) according to claim 1, **characterized in that** the PCB (7) comprises a second side with a continuous metal surface area (56).

5. Arrangement according to claim 4, **characterized in that** the continuous metal surface area (56) is a thin copper layer of about 70 µm thickness,

6. Arrangement according to claim 4, **characterized in that** the continuous metal surface area (56) is sealed with a thin solder-stopping lacquering (57).

7. Arrangement (1, 31; 41) according to claim 1, **characterized in that** the PCB (7) comprises a thin electrically isolating foil.

8. Arrangement (1, 31; 41) according to claim 1, **characterized in that** the PCB (7) comprises a thin, non-metallic lacquering, in particular a solder-stopping lacquering (54; 57), on at least part of the first and/or second side.

9. Arrangement (1, 31; 41) according to claim 1, **characterized in that** the power devices (3) are arranged arcuated.

10. Method for producing an arrangement (1, 31; 41) according to claim 1 comprising the step of
soldering each power device (3) to one separate metal face (6; 52) with cooling tabs (5) located at one side face of the power device (3), by an SMD (=surface mounted device) reflow procedure,
during which the power devices (3) are automatically oriented by capillary forces and interfacial energies, with the help of the cooling tabs (5).

## Patentansprüche

1. Anordnung (1, 31; 41), die mehrere
Leistungsvorrichtungen (3), insbesondere einen Leistungstransistor, und Mittel zum Kühlen der Leistungsvorrichtungen (3) umfasst,
wobei die Mittel eine getrennte Metallfläche (6; 52) für jede Leistungsvorrichtung (3) und
eine gedruckte Leiterplatte (= PCB) (7) aufweisen, wobei die PCB (7) eine erste Seite mit den Metallflächen (6; 52) aufweist, wobei jede Leistungsvorrichtung (3) an eine getrennte Metallfläche (6; 52) gelötet ist,
wobei die getrennten Metallflächen (6; 52) in einer Reihe angeordnet sind,
**dadurch gekennzeichnet, dass** die PCB (7) biegsam ist und dass benachbarte Metallflächen (6; 52) interdigital angeordnet sind.

2. Anordnung nach Anspruch 1, **dadurch gekennzeichnet, dass** die interdigital angeordneten benachbarten Metallflächen (6; 52) wellige Kantenumrisse haben.

3. Anordnung (1, 31; 41) nach Anspruch 1, **dadurch gekennzeichnet, dass** die Metallfläche (6; 32) ein Teil aus Metallblech (32), insbesondere ein Teil aus Kupferblech, umfasst.

4. Anordnung (1, 31; 41) nach Anspruch 1, **dadurch gekennzeichnet, dass** die PCB (7) eine zweite Seite mit einem durchgängigen Metalloberflächenbereich (56) aufweist.

5. Anordnung nach Anspruch 4, **dadurch gekennzeichnet, dass** der durchgängige Metalloberflächenbereich (56) eine dünne Kupferschicht mit einer Dicke von etwa 70 µm ist.

6. Anordnung nach Anspruch 4, **dadurch gekennzeichnet, dass** der durchgängige Metalloberflächenbereich (56) mit einem dünnen Lötmittelbarrierenlack (57) versiegelt ist.

7. Anordnung (1, 31; 41) nach Anspruch 1, **dadurch gekennzeichnet, dass** die PCB (7) eine dünne, elektrisch isolierende Folie aufweist.

8. Anordnung (1, 31; 41) nach Anspruch 1, **dadurch gekennzeichnet, dass** die PCB (7) einen dünnen, nichtmetallischen Lack, insbesondere einen Lötmittelbarrierenlack (54; 57) wenigstens auf einem Teil der ersten und/oder der zweiten Seite aufweist.

9. Anordnung (1, 31; 41) nach Anspruch 1, **dadurch gekennzeichnet, dass** die Leistungsvorrichtungen (3) bogenförmig angeordnet sind.

10. Verfahren zum Herstellen einer Anordnung (1, 31; 41) nach Anspruch 1, das den folgenden Schritt umfasst: Löten jeder Leistungsvorrichtung (3) an eine getrennte Metallfläche (6; 52) mit Kühlungslaschen (5) durch eine SMD-Rückflussprozedur (SMD = oberflächenmontierte Vorrichtung), währenddessen die Leistungsvorrichtungen (3) durch Kapillarkräfte und Grenzflächenenergien mit Hilfe der Kühlungslaschen (5) automatisch orientiert werden.

## Revendications

1. Agencement (1, 31 ; 41) comprenant une multitude de dispositifs de puissance (3), comprenant en particulier un transistor de puissance, et des moyens pour refroidir les dispositifs de puissance (3),
dans lequel les moyens comprennent une face métallique (6 ; 52) séparée pour chaque dispositif de puissance (3) et une carte de circuit imprimé (PCB) (7), la PCB (7) comprenant un premier côté avec les faces métalliques (6 ; 52), chaque dispositif de puissance (3) étant soudé à une face métallique (6 ; 52) séparée, les faces métalliques (6 ; 52) séparées étant agencées en série, **caractérisé en ce que** la PCB (7) est souple, et **en ce que** les faces métalliques (6 ; 52) voisines sont interdigitées.

2. Agencement selon la revendication 1, **caractérisé en ce que** les faces métalliques (6 ; 52) voisines interdigitées ont des contours de bord de forme ondulée.

3. Agencement (1, 31 ; 41) selon la revendication 1, **caractérisé en ce que** la face métallique (6 ; 32) comprend un morceau de feuille (32), en particulier un morceau de feuille de cuivre.

4. Agencement (1, 31 ; 41) selon la revendication 1, **caractérisé en ce que** la PCB (7) comprend un deuxième côté avec une aire de surface métallique continue (56).

5. Agencement selon la revendication 4, **caractérisé en ce que** l'aire de surface métallique continue (56) est une mince couche de cuivre d'une épaisseur d'environ 70 µm.

6. Agencement selon la revendication 4, **caractérisé en ce que** l'aire de surface métallique continue (56) est scellée avec un mince laquage d'arrêt de soudure (57).

7. Agencement (1, 31 ; 41) selon la revendication 1, **caractérisé en ce que** la PCB (7) comprend une mince feuille électriquement isolante.

8. Agencement (1, 31 ; 41) selon la revendication 1, **caractérisé en ce que** la PCB (7) comprend un mince laquage non métallique, en particulier un laquage d'arrêt de soudure (54 ; 57), sur au moins une partie du premier et/ou du deuxième côté.

9. Agencement (1, 31 ; 41) selon la revendication 1, **caractérisé en ce que** les dispositifs de puissance (3) sont agencés en forme d'arc.

10. Procédé de production d'un agencement (1, 31 ; 41) selon la revendication 1, comprenant l'étape consistant à souder chaque dispositif de puissance (3) sur une face métallique (6 ; 52) séparée avec des languettes de refroidissement (5) situées au niveau d'une face latérale du dispositif de puissance (3) par une procédure de refusion de SMD (dispositif monté en surface), pendant laquelle les dispositifs de puissance (3) sont orientés automatiquement par des forces capillaires et des énergies interfaciales, à l'aide des languettes de refroidissement (5).
